# EUROPEAN PATENT APPLICATION

(11) **EP 1 770 750 A2**
(43) Date of publication of application: **04.04.2007**
(21) Application number: 06255097.5
(22) Date of filing: 02.10.2006
(51) Int. Cl.: H01J 17/49

(54) **Plasma display apparatus**

(30) Priority: 30.09.2005 KR 20050092629; 22.09.2006 KR 20060092505
(71) Applicant: LG ELECTRONICS INC., Seoul (KR)
(72) Inventor: Yu, Park, Mapo-gu, Seoul (KR)
(74) Representative: Palmer, Jonathan R.

(57) **Abstract**

In a plasma display apparatus, as a filter comprises a dark-colored part, contrast characteristics are improved and as palladium (Pd) is comprised in an electromagnetic wave shielding layer of the filter, a manufacturing cost can be reduced.

The plasma display apparatus comprises a plasma display panel that displays an image; a plasma display panel that displays an image; and a filter provided to a front of the plasma display panel; the filter comprises: a substrate; a metal layer formed on the substrate; a base layer formed on the substrate; and a dark-colored part provided to the base layer, wherein a traveling direction of the dark-colored part has a angle from 5° to 80° on the basis of the bottom of the base layer.

## Description

### BACKGROUND

### Field

This document relates to a plasma display apparatus.

### Description of the Background Art

A plasma display apparatus comprises a plasma display panel that displays an image and a filter provided to a front of the plasma display panel.

In general, in the plasma display panel, a phosphor layer is formed within a discharge cell partitioned by a barrier rib and a plurality of electrodes is formed.

A driving signal is supplied to the discharge cell through the electrode.

A discharge is generated by a driving signal supplied within the discharge cell. When a discharge is generated by a driving signal within the discharge cell, a discharge gas filled within the discharge cell generates light such as ultraviolet rays, light such as the ultraviolet rays allows a phosphor formed within the discharge cell to emit light, thereby generating visible light. An image is displayed on a screen of the plasma display panel by the visible light.

### SUMMARY

In an aspect, a plasma display apparatus comprising: a plasma display panel that displays an image; and a filter provided to a front of the plasma display panel; the filter comprises: a substrate; a metal layer formed on the substrate; a base layer formed on the substrate; and a dark-colored part provided to the base layer, wherein a traveling direction of the dark-colored part has a angle from 5° to 80° on the basis of the bottom of the base layer.

### BRIEF DESCRIPTION OF THE DRAWINGS

The implementation of the invention will be described in detail with reference to the following drawings in which like numerals refer to like elements.

FIG. 1 is a view illustrating a filter according to an implementation of this document;

FIG. 2 is a view illustrating a dark-colored part and a base layer;

FIG. 3 is a view illustrating a function of the dark-colored part;

FIGS. 4A to 4E are views illustrating another type of the dark-colored part;

FIGS. 5A and 5B are views illustrating a traveling direction of the dark-colored part;

FIGS. 6A to 6C are views illustrating various types of the dark-colored part;

FIG. 7 is a view illustrating an example using two or more dark-colored parts having a different pattern;

FIG. 8 is a view illustrating another structure of the dark-colored part;

FIGS. 9A to 9C are views illustrating an electromagnetic-wave shielding layer;

FIG. 10 is a view illustrating an example of another filter that may be applied to an implementation of this document;

FIG. 11 is a view illustrating a plasma display apparatus according to an implementation of this document;

FIGS. 12A and 12B are views illustrating a disposition relationship of a filter and a plasma display panel;

FIG. 13 is a view illustrating an example of a plasma display panel that can be comprised in a plasma display apparatus according to an implementation of this document;

FIG. 14 is a view illustrating an example in which at least one of a first electrode and a second electrode is a plurality of layers;

FIG. 15 is a view illustrating an example in which at least one of a first electrode and a second electrode is one layer;

FIG. 16 is a view illustrating an image frame for embodying a gray level of an image in a plasma display apparatus according to an implementation of this document;

FIG. 17 is a view illustrating an example of an operation of a plasma display apparatus according to an implementation of this document;

FIGS. 18A and 18B are views illustrating another type of a ramp-up signal or a second ramp-down signal; and

FIG. 19 is a view illustrating another type of a sustain signal.

### DETAILED DESCRIPTION

Implementations of the this document will be described in a more detailed manner with reference to the drawings.

In an aspect, a plasma display apparatus comprising: a plasma display panel that displays an image; and a filter provided to a front of the plasma display panel; the filter comprises: a substrate; a metal layer formed on the substrate; a base layer formed on the substrate; and a dark-colored part provided to the base layer, wherein a traveling direction of the dark-colored part has a angle from 5° to 80° on the basis of the bottom of the base layer.

In another aspect, a plasma display apparatus comprising: a plasma display panel that displays an image; and a filter provided to a front of the plasma display panel; the filter comprises: a substrate; at least one transparent layer formed on the substrate; at least one metal layer adjacently formed on the transparent layer; a base layer formed on the substrate; and a dark-colored part provided to the base layer.

In another aspect, a plasma display apparatus comprising: a plasma display panel that displays an image; and a filter provided to a front of the plasma display panel; the filter comprises: a substrate; a mesh type metal layer that is formed on the substrate; a base layer that is formed on the substrate; and a dark-colored part provided to the base layer, wherein a line width of the metal layer is 10 µm to 30 µm.

Hereinafter, a plasma display apparatus according to an implementation of this document will be described in detail with reference to the attached drawings.

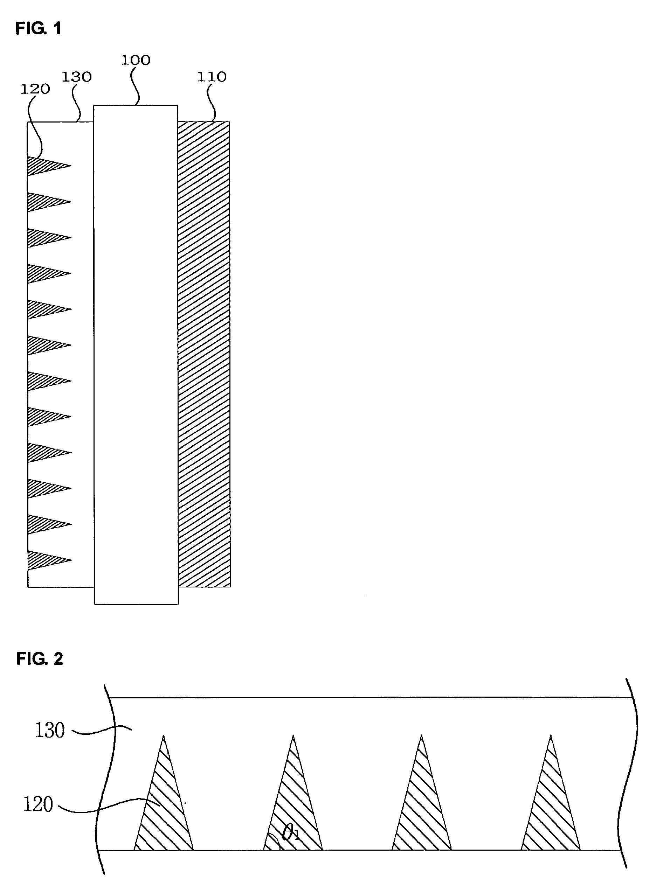

FIG. 1 is a view illustrating a filter according to an implementation of this document.

Referring to FIG. 1, a filter according to an implementation of this document comprises a substrate 100, an electromagnetic wave shielding layer 110, a base layer 130, and a dark-colored part 120.

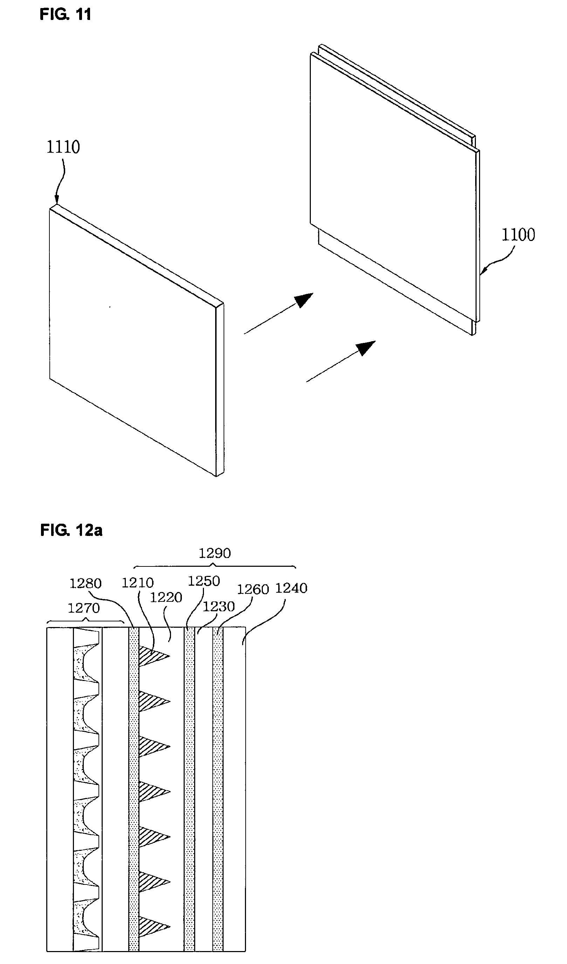

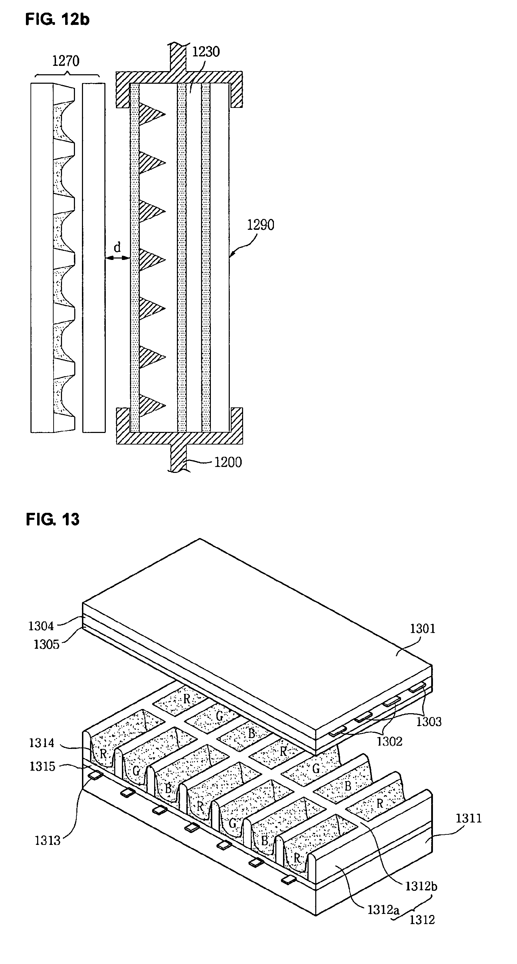

The substrate 100 may comprise a glass material or a resin material. For example, when the substrate 100 comprises a glass material, the substrate 100 is classified into a glass filter type and when the substrate 100 comprises a resin material, the substrate 100 is classified into a film filter type. This will be described in detail in FIGS. 12A and 12B.

The electromagnetic wave shielding layer 110 is formed on the substrate 100 and will be apparent through the following description.

FIG. 2 is a view illustrating a dark-colored part and a base layer.

Referring to FIG. 2, the base layer 130 is formed on a lower part of the substrate 100. The base layer 130 may be substantially transparent.

The dark-colored part 120 provided to the base layer 130 and may comprise a material having a refractive index smaller than that of the base layer 130. The dark-colored parts 120 may be provided apart a predetermined interval.

Furthermore, the dark-colored part 120 may have a color darker than that of the base layer 130. For example, the dark-colored part 120 comprises a material such as carbon and thus may have a substantially black color.

Furthermore, the dark-colored part 120 may comprise a part whose a width gradually decrease as it advances toward a direction of the base layer 130. Accordingly, one surface of the base layer 130 parallel to a base of the dark-colored part 120 and the dark-colored part 120 may form a predetermined angle θ1. This angle θ1 may be set to about 70° or more and less than 90°.

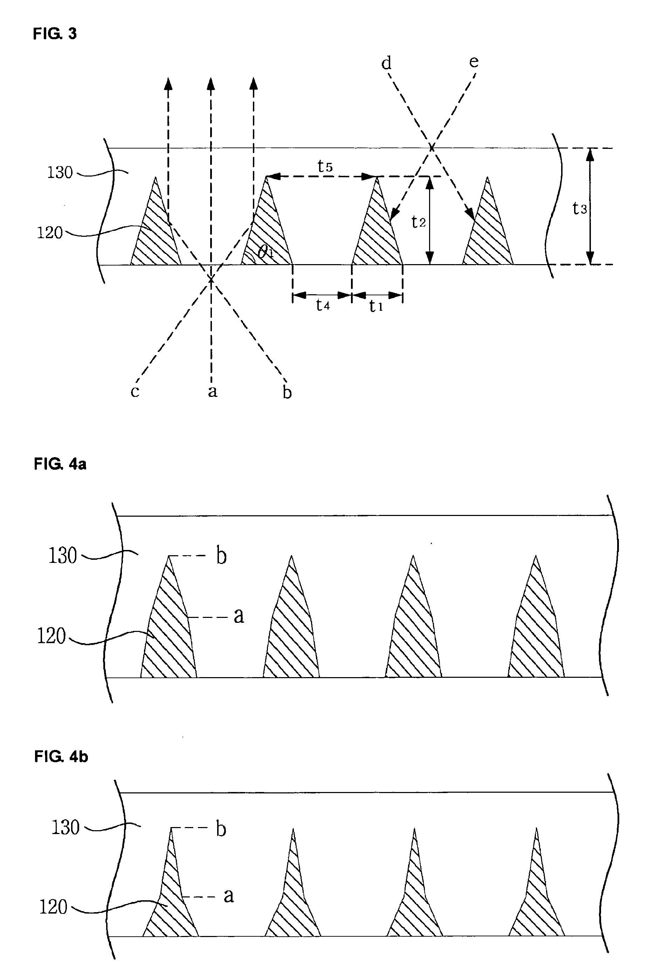

A function of the dark-colored part 120 will be described with reference to FIG. 3.

FIG. 3 is a view illustrating a function of the dark-colored part.

Referring to FIG. 3, light generated at "a" point at the inside of a filter directly emits to the outside and light generated at "b" and "c" points is totally reflected by the dark-colored part 120 to emit to the outside.

However, light entered from "d" and "e" points positioned at the outside of the filter may be absorbed into the dark-colored part 120. This is generated because a refractive index of the dark-colored part 120 is smaller than that of the base layer 130 and one surface of the base layer 130 parallel to a base of the dark-colored part 120 and the dark-colored part 120 can form a predetermined angle θ1.

As light generated at the inside of the filter is effectively emitted to the outside and light entered from the outside of the filter is absorbed, contrast characteristics of light emitted from the inside of the filter can be improved.

In order to more effectively absorb light entered from the outside of the filter and more effectively emit light generated at the inside of the filter, a refractive index of the dark-colored part 120 is 0.8 to 0.999 times greater than a refractive index of the base layer 130.

Furthermore, a height t3 of the base layer 130 is 1.01 to 2.25 times greater than a height t2 of the dark-colored part 120.

Accordingly, production efficiency in a manufacturing process can be improved and solidity of the filter can be fully secured, light entered from the outside of the filter can be fully shielded and transparency of light emitted from the inside of the filter can be fully secured.

Furthermore, a gap t4 between the dark-colored parts 120 in a bottom area is 1.1 to 5 times greater than a width t1 of a base of the dark-colored part 120. Accordingly, an aperture ratio of the filter can be fully secured, light entered from the outside of the filter can be fully shielded, and a manufacturing process of the dark-colored part 120 can be easily performed.

Furthermore, a gap t5 between the dark-colored parts 120 in an upper area is 1.1 to 3.25 times greater than a gap t4 between the dark-colored parts 120 in a bottom area. Accordingly, an aperture ratio of the filter can be fully secured, and as an angle θ1 of the dark-colored part 120 may be ideally set, light entered from the outside of the filter can be fully shielded.

Furthermore, a height t2 of the dark-colored part 120 is 0.89 to 4.25 times greater than a gap t4 between the dark-colored parts 120 in a bottom area. Accordingly, an aperture ratio of the filter can be fully secured, and light entered from the outside of the filter can be fully shielded.

For example, a width t1 of a base of the dark-colored part 120 is 18 µm to 35 µm.

Otherwise, a height t2 of the dark-colored part 120 is 80 µm to 170 µm.

Otherwise, a height t3 of the base layer 130 is 100 µm to 180 µm.

Otherwise, a gap t4 between the dark-colored parts 120 in a bottom area is 40 µm to 90 µm.

Otherwise, a gap t5 between the dark-colored parts 120 in an upper area is 90 µm to 130 µm.

FIGS. 4A to 4E are views illustrating another form of the dark-colored part.

First, referring to FIG. 4A, the dark-colored part 120 may comprise a first part (a) having a first width and a second part (b) having a second width. Here, a distance between the first part (a) and the substrate (not shown) is shorter than that between the second part (b) and the substrate, and the first width is larger than the second width. That is, a width of the second part (b) closer to the substrate that is not shown is smaller than that of the first part (a).

For example, as the dark-colored part 120 advances toward a direction of the substrate, the width may be decreased.

The dark-colored part may comprise two parts in which a decreasing degree of the width is different as it advances toward a direction of the substrate. For example, the width decrease with a first ratio up to "a" point and the width may be decreased with a second ratio greater than the first ratio from "b" point.

Next, referring to FIG. 4B, unlike FIG. 4A, the width of the dark-colored part 120 decreases with the first ratio up to "a" point and decreases with the second ratio smaller than the first ratio from "b" point.

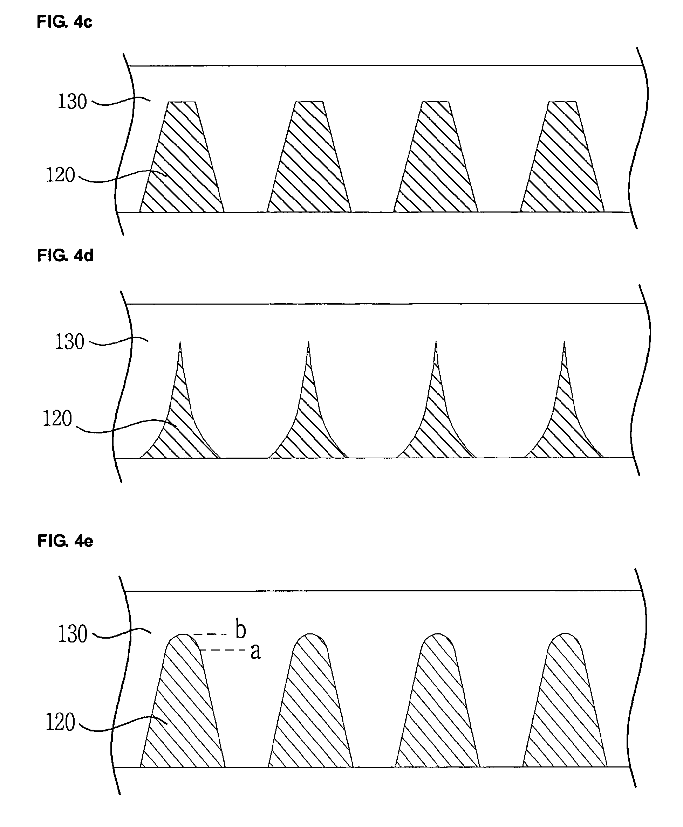

Next, referring to FIG. 4C, a tip of the dark-colored part 120 may have a substantially flat form.

Next, referring to FIG. 4D, a side surface of the dark-colored part 120 may form a smooth curved line.

Next, in FIG. 4E, a side surface of the dark-colored part 120 may be a substantially straight line form up to "a" point and may be a curved line form from "b" point. For example, a tip of the dark-colored part 120 comprises a curved surface.

As described above, a form of the dark-colored part may be variously changed.

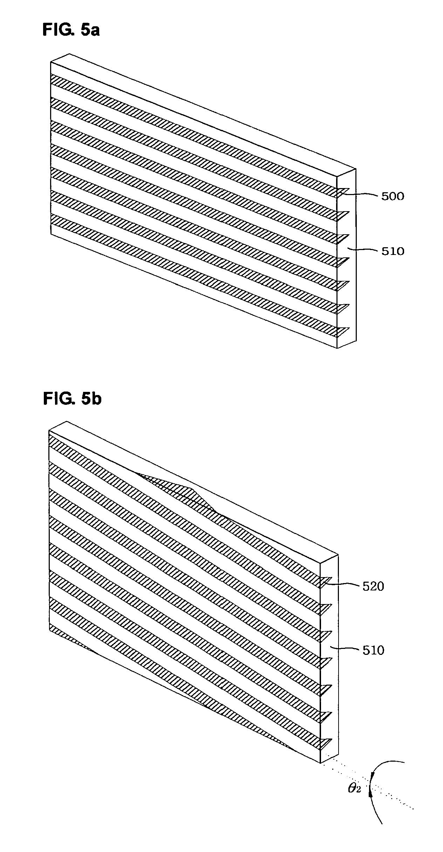

FIGS. 5A and 5B are views illustrating a traveling direction of the dark-colored part.

First, in FIG. 5A, a traveling direction of the dark-colored part 500 and a basis of the bottom of a base layer 510 may be substantially parallel to each other.

Next, referring to FIG. 5B, a traveling direction of the dark-colored part 520 has a predetermined angle θ2 on the basis of the bottom of a base layer 510. from 5° to 80°

In this way, if the traveling direction of the dark-colored part 520 has a angle θ2 on the basis of the bottom of a base layer 510, an interference fringe, i.e., a moire fringe generated when two or more periodic patterns overlap can be shielded.

Furthermore, in order to more effectively shield such a moire fringe, a predetermined angle θ2 in which the traveling direction of the dark-colored part 520 may has a angle from 5° to 80° on the basis of the bottom of a base layer 510.

FIGS. 1 to 4 shows only a stripe type of the dark-colored part, but a type of the dark-colored part may be variously changed.

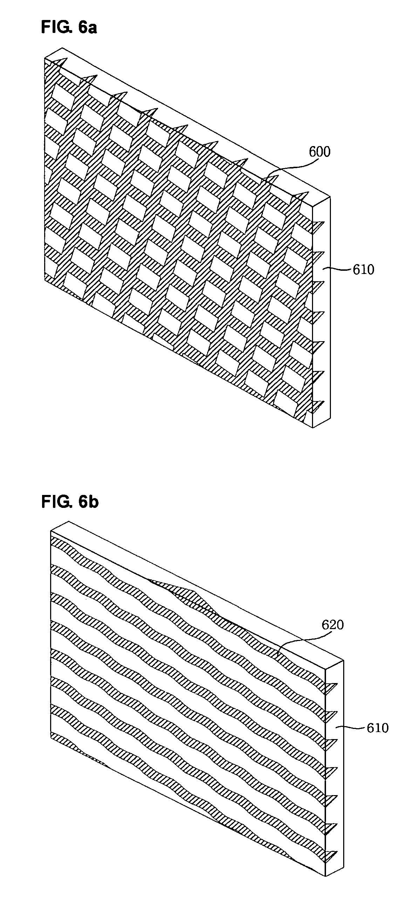

FIGS. 6A to 6C are views illustrating various types of the dark-colored part.

First, referring to FIG. 6A, the dark-colored part 600 may be formed in a matrix type.

Next, referring to FIG. 6B, the dark-colored part 620 may be formed in a wave type.

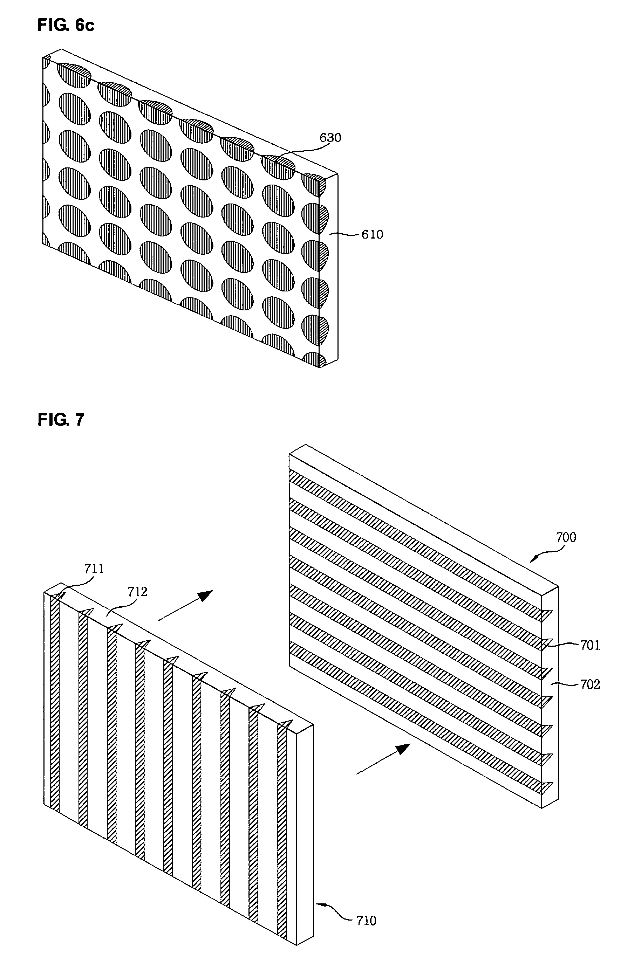

Next, referring to FIG. 6C, the dark-colored part 630 may be formed in a protrusion type. For example, a plurality of the dark-colored parts 630 of a protrusion type having a hemisphere shape may be arranged with a predetermined interval.

As described above, a type of the dark-colored part may be variously changed.

FIG. 7 is a view illustrating an example using two or more dark-colored parts having a different pattern.

Referring to FIG. 7, a first light shielding unit 700 comprising a base layer 702 and a first dark-colored part 701 parallel to a long base of the base layer 702 and a second light shielding unit 710 comprising a base layer 712 and a second dark-colored part 711 parallel to a short base of the base layer 712 may be comprised in one filter.

In this way, if two or more dark-colored parts having a different pattern are used, a viewing angle of the filter may be variously adjusted.

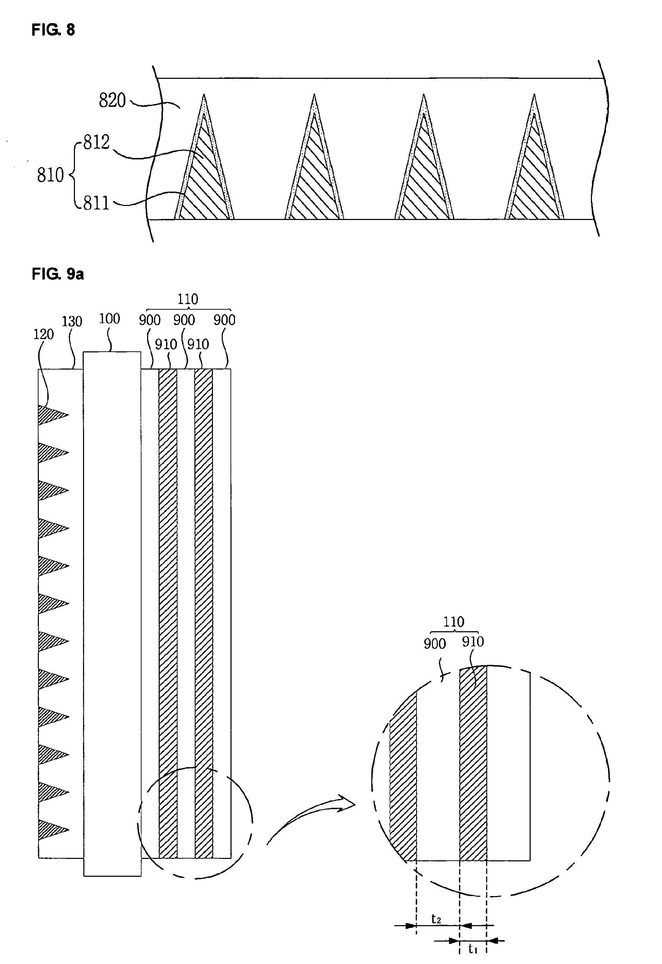

FIG. 8 is a view illustrating another structure of the dark-colored part.

Referring to FIG. 8, the dark-colored part 810 has a plurality of layers. For example, the dark-colored part 810 may comprise a first dark-colored part layer 811 and a second dark-colored part layer 812. Here, the first dark-colored part layer 811 may be formed to cover the second dark-colored part layer 812.

Furthermore, the first dark-colored part layer 811 may comprise a material whose a refractive index is smaller than that of a base layer 820.

Furthermore, a refractive index of the second the dark-colored part layer 812 may be equal to or different from that of the first dark-colored part layer 811. For example, a refractive index of the second dark-colored part layer 812 is smaller than that of the first dark-colored part layer 811.

FIGS. 9A to 9B are views illustrating an electromagnetic-wave shielding layer.

First, referring to FIG. 9A, a filter according to an implementation of this document comprises a substrate 100, an electromagnetic wave shielding layer 110, a base layer 130, and a dark-colored part 120, and the electromagnetic wave shielding layer 110 comprises at least one transparent layer 900 and at least one metal layer 910. Here, the substrate 100, the base layer 130, and the dark-colored part 120 were previously described in detail and thus descriptions thereof will be omitted.

The transparent layer 900 is formed on the substrate 100 and the metal layer 910 is formed to be adjacent to the transparent layer over the substrate 100. For example, the transparent layer 900 and the metal layer 910 may be alternately stacked.

The electromagnetic wave shielding layer 110 of FIG. 9A may be classified into a sputter type electromagnetic wave shielding layer. The sputter type means a structure in which two or more different conductive layers are stacked.

The transparent layer 900 comprises an indium-tin oxide (ITO) material and thus the transparent layer 900 may be substantially transparent. Furthermore, the metal layer 910 may comprise a silver (Ag) material.

If at least one of the transparent layer 900 that is substantially transparent and the metal layer 910 comprising a silver (Ag) material having excellent electrical conductivity are stacked, light transmittance can be fully secured and thus electrical conductivity can be fully increased.

Accordingly, electric charges generating electromagnetic waves can be fully absorbed and thus generation of electro magnetic interference (EMI) can be reduced.

At least one of the metal layer 910 and the transparent layer 900 may comprise a palladium (Pd) material. For example, the metal layer 910 may comprise a palladium (Pd) material.

Palladium (Pd) has electrical conductivity corresponding to silver (Ag) and a cost thereof is remarkably lower than silver (Ag). Accordingly, when the metal layer 910 comprises palladium (Pd), the metal layer 910 can reduce a manufacturing cost while sustaining electrical conductivity.

For example, as described with reference to FIGS. 1 to 7, the filter that comprises the dark-colored part may have a manufacturing cost relatively higher than the filter that does not comprise the dark-colored part. In order to prevent rapid increase of the manufacturing cost, it is advantageous to use palladium having a relatively low cost (Pd) in the electromagnetic wave shielding layer.

At least one of the metal layer 910 and the transparent layer 900 may be comprised palladium (Pd) of 0.001wt% to 20wt%. For example, in the metal layer 910, palladium (Pd) of 0.001wt% to 20wt% and silver (Ag) of 80wt% to 99.999wt% may be comprised.

If a content of palladium (Pd) is set to 0.001wt% to 20wt%, electrical conductivity can be fully highly sustained, abrupt increase of a manufacturing cost can be more effectively prevented, and a manufacturing process of the metal layer 910 or the transparent layer 900 can be easily performed.

Furthermore, as described above, if the filter comprises the dark-colored part, a part of light emitted from the inside of the filter may be absorbed by the dark-colored part. Accordingly, entire brightness of light emitted to the outside of the filter can be decreased. As in FIG. 9A, if a sputter type electromagnetic wave shielding layer is applied in which at least one transparent layer 900 and at least one metal layer 910 are stacked, abrupt decrease in brightness of light emitted to the outside of the filter can be prevented.

The sum of the layer number of the transparent layer 900 and the layer number of the metal layer 910 to be stacked, i.e., the total number of the transparent layer 900 and the metal layer 910 may be set to 5 to 13. If the total number of the transparent layer 900 and the metal layer 910 is set to 5 to 13, light transmittance of the filter can be prevented from excessively decreasing and electrical conductivity of the electromagnetic wave shielding layer can be fully sustained.

Furthermore, a thickness t2 of the transparent layer 900 may be set to 300Å to 800Å. In this way, if a thickness of the transparent layer 900 is set, excessive increase of a manufacturing cost can be prevented and electrical conductivity of the transparent layer 900 can be fully secured.

A thickness t1 of the metal layer 910 may be set to 100Å to 200Å. In this way, if a thickness of the metal layer 910 is set, light transmittance and electrical conductivity can be fully secured.

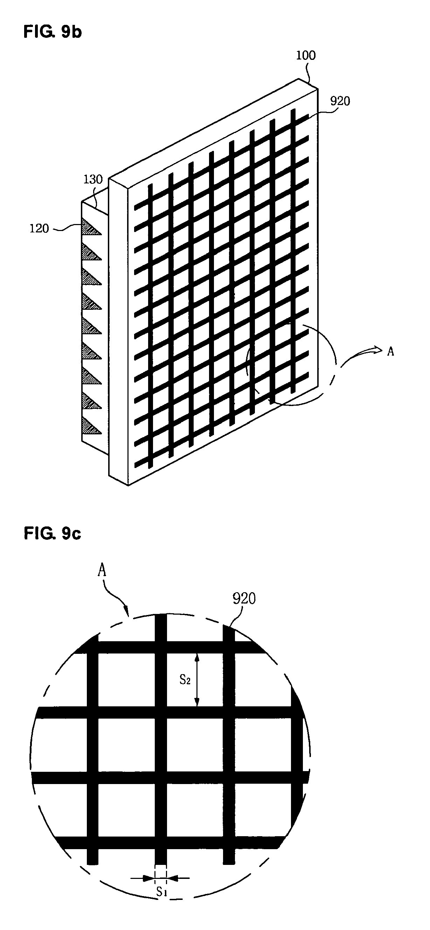

Next, referring to FIG. 9B, a filter according to an implementation of this document may comprise the substrate 100, the mesh type metal layer 920, the base layer 130, and the dark-colored part 120. Here, the mesh type metal layer 920 is an electromagnetic wave shielding layer. The substrate 100, the base layer 130, and the dark-colored part 120 were previously described in detail and thus description thereof will be omitted. The case of FIG. 9B may be classified into a mesh type electromagnetic wave shielding layer.

The mesh type electromagnetic wave shielding layer can be fully absorbed electric charges that generate electromagnetic waves and thus generation of electro magnetic interference (EMI) can be reduced.

The mesh type metal layer may comprise palladium (Pd). Palladium (Pd) was previously described in detail and thus description thereof will be omitted.

Furthermore, in order to prevent reflection of light by the mesh type metal layer 920, a color of the mesh type metal layer 920 may become darker than that of the substrate 100. For example, although not shown in the figure, by coating a material having a substantially black color, for example, a carbon material in an upper part of the mesh type metal layer 920, reflection of light by the mesh type metal layer 920 can be prevented. Otherwise, by forming or coating a material having a substantially black color in a lower part of the mesh type metal layer 920, coherent light emitted from the plasma display panel can be absorbed.

A structure of the mesh type metal layer 920 is shown in detail in FIG. 9C.

As in FIG. 9C, a line width S1 of the mesh type metal layer 920 may be set to 10 µm to 30 µm. Furthermore, a shortest distance S2 between lines of the mesh type metal layer 920 may be set to 200 µm to 300 µm. The reason of setting is as follows.

As shown in FIGS. 1 to 7, if the filter comprises the dark-colored part, a part of light emitted from the inside of the filter may be absorbed by the dark-colored part. Accordingly, entire brightness of light emitted to the outside of the filter can be decreased. Here, if the line width S1 of the mesh type metal layer 920 is set to 10 µm to 30 µm or a shortest distance S2 between lines of the mesh type metal layer 920 is set to 200 µm to 300 µm, light is fully prevented from being shielded by the mesh type metal layer 920 while fully sustaining electrical conductivity of the electromagnetic wave shielding layer, thereby fully highly sustaining light transmittance of the filter.

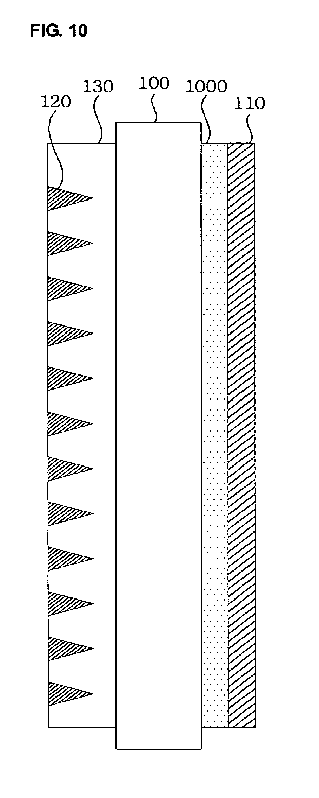

FIG. 10 is a view illustrating an example of another filter that may be applied to an implementation of this document.

Referring to FIG. 10, a near-infrared ray shielding layer 1000 may be further comprised between the substrate 100 and the electromagnetic wave shielding layer 110.

The near-infrared ray shielding layer 1000 absorbs or reflects near-infrared rays (NIR), thereby shielding near-infrared rays. As the near-infrared ray shielding layer 1000 shields near-infrared rays, an erroneous operation of other appliances due to the near-infrared rays can be prevented.

The near-infrared ray shielding layer 1000 may be made of an acryl adhesive, which is a homopolymer or copolymer that is mixed 75 to 99.89wt% of a (meta)acrylic acid ester monomer having an alkyl group of 1 to 12 carbon atoms with 0.1 to 20wt% of an α, β-unsaturated carboxylic acid monomer that is a functional monomer or 0.01 to 5 wt% of a polymerizable monomer having a hydroxyl group.

A thickness of the near-infrared ray shielding layer 1000 may be set to 80 µm to 150 µm. If the thickness of the near-infrared ray shielding layer 1000 is set to 80 µm to 150 µm, near-infrared ray generating upon driving can be fully reflected or absorbed and light transmittance of the filter can be fully sustained.

Other functional layers in addition to the near-infrared ray shielding layer 1000 may be also stacked. For example, although not shown in the figure, another functional layer such as a color layer, an anti-glare layer, or an anti-reflection layer may be further stacked.

The filter provided to a front of the plasma display panel to form a plasma display apparatus and this will be described hereinafter.

FIG. 11 is a view illustrating a plasma display apparatus according to an implementation of this document.

Referring to FIG. 11, the plasma display apparatus according to an implementation of this document comprises a plasma display panel 1100 for displaying an image and a filter 1110. The filter 1110 was previously described and thus descriptions thereof will be omitted.

If the filter 1110 described in detail with reference to FIGS. 1 to 9 provided to a front of the plasma display panel 1100, contrast characteristic of an image displayed in the plasma display panel 1100 can be improved and a manufacturing cost of the plasma display apparatus can be reduced.

FIGS. 12A and 12B are views illustrating a disposition relationship of a filter and a plasma display panel.

Referring to FIG. 12A, a first adhesion layer 1280 is formed on the front surface of a plasma display panel 1270, and a filter 1290 may be attached in the first adhesion layer 1280. For example, the filter 1290 may be attached on the front surface of the plasma display panel 1270 through a method such as laminating. The filter 1290 is a film filter type.

Here, reference numeral 1210 indicates a dark-colored part, reference numeral 1220 indicates a base layer, reference numeral 1230 is a substrate, and reference numeral 1240 indicates an electromagnetic wave shielding layer. As in FIG. 12A, when the filter is a film filter type, the substrate 1230 may comprise a resin material.

Furthermore, in the filter 1290, a second adhesion layer 1250 may be formed between the base layer 1220 and the substrate 1230 and a third adhesion layer 1260 may be formed between the substrate 1230 and the electromagnetic wave shielding layer 1240.

In a case where a thickness of a first adhesion layer 1280 for bonding the filter 1290 and the plasma display panel 1270 is excessively thick, light generated in the plasma display panel 1270 may be prevented from emitting to the outside and in a case where a thickness of the first adhesion layer 1280 is excessively thin, adhesive strength of the plasma display panel 1270 and the filter 1290 may be deteriorated.

Accordingly, a thickness of the first adhesion layer 1280 may be set to about 10 µm to 50 µm or 20 µm to 40 µm.

Next, referring to FIG. 12B, the filter 1290 may be provided apart a predetermined distance d from the plasma display panel 1270. For example, the filter 1290 is supported by a supporter 1200 to be provided apart "d" distance from a front surface of the plasma display panel 1270. In this case, the filter 1290 is a glass filter type. Here, the substrate 1230 may comprise a glass material.

FIG. 13 is a view illustrating an example of a plasma display panel that may be comprised in a plasma display apparatus according to an implementation of this document.

Referring to FIG. 13, a plasma display panel that may be comprised in a plasma display apparatus according to an implementation of this document may be formed by coupling of a front substrate 1301 in which a first electrode 1302 (Y) and a second electrode 1303 (Z) parallel to each other are formed and a rear substrate 1311 in which a third electrodes 1313 (X) is formed in which the first electrode 1302 (Y) and the second electrode 1303 (Z) intersect.

In the upper part of the front substrate 1301, an electrode, for example, the first electrode 1302 (Y) and the second electrode 1303 (Z) may be formed. The first electrode 1302 (Y) and the second electrode 1303 (Z) may generate a discharge in a discharge space, i.e., a discharge cell and may sustain a discharge of the discharge cell.

In the upper part of the front substrate 1301 in which the first electrode 1302 (Y) and the second electrode 1303 (Z) are formed, a dielectric layer, for example, an upper dielectric layer 1304 may be formed to cover the first electrode 1302 (Y) and the second electrode 1303 (Z).

The upper dielectric layer 1304 limits a discharge current of the first electrode 1302 (Y) and the second electrode 1303 (Z) and may be isolated between the first electrode 1302 (Y) and the second electrode 1303 (Z).

In the upper surface of the upper dielectric layer 1304, a protection layer 1305 may be formed to facilitate a discharge condition. The protection layer 1305 may be formed through a method of depositing a material such as magnesium oxide (MgO) to an upper part of an upper dielectric layer 1304.

An electrode, for example, a third electrode 1313 (X) is formed on a rear substrate 1311, and a dielectric layer, for example, a lower dielectric layer 1315 may be formed to cover the third electrode 1313 (X) on the rear substrate 1311 in which the third electrode 1313 (X) is formed.

The lower dielectric layer 1315 may isolate the third electrode 1313 (X).

A stripe type, a well type, delta type, and a honeycomb type barrier rib 1312 for partitioning a discharge space, i.e., a discharge cell may be formed in the upper part of the lower dielectric layer 1315. Accordingly, red R, green G, and blue B discharge cells may be formed between the front substrate 1301 and the rear substrate 1311.

Furthermore, in addition to the red R, green G, and blue B discharge cells, a white W or yellow Y discharge cell may be formed.

A pitch of the red R, green G, and blue B discharge cells in a plasma display panel that may be comprised in a plasma display apparatus according to an implementation of this document may be substantially equal, but in order to adjust a color temperature in the red R, green G, and blue B discharge cells, pitches of the red R, green G, and blue B discharge cells may be different from each other.

In this case, all pitches of each of the red R, green G, and blue B discharge cells may be different from each other, but a pitch of at least one of the red R, green G, and blue B discharge cells may be different from that of other discharge cells. For example, a pitch of the red R discharge cell is smallest and pitches of the green G and blue B discharge cells enlarge may be larger than that the red R discharge cell.

A pitch of the green G discharge cell may be substantially equal to or different from that of the blue B discharge cell.

Furthermore, a plasma display panel that may be comprised in the plasma display apparatus according to an implementation of this document may have a structure of various shape of barrier rib as well as a structure of the barrier rib 1312 shown in FIG. 13. For example, the barrier rib 1312 comprises a first barrier rib 1312b and a second barrier rib 1312a and may have a differential barrier rib structure in which a height of the first barrier rib 1312b and a height of the second barrier rib 1312a are different from each other, a channel type barrier rib structure in which a channel that may be used as an exhaust passage is formed in at least one of the first barrier rib 1312b and the second barrier rib 1312a, and a hollow type barrier rib structure in which a hollow is formed in at least one of the first barrier rib 1312b and the second barrier rib 1312a.

In the differential barrier rib structure, a height of the first barrier rib 1312b among the first barrier rib 1312b or the second barrier rib 1312a may be lower than that of the second barrier rib 1312a. Furthermore, in the channel type barrier rib structure or the hollow type barrier rib structure, a channel or a hollow may be formed in the first barrier rib 1312b.

In the plasma display panel that may be comprised in the plasma display apparatus according to an implementation of this document, each of the red R, green G, and blue B discharge cells is arranged on the same line, but each of the red R, green G, and blue B discharge cells may be arranged in other shapes. For example, delta type arrangement may be formed in which the red R, green G, and blue B discharge cells are arranged in a triangle shape. Furthermore, the discharge cell may have various polygonal shapes such as a quadrangular shape, a pentagonal shape, and a hexagonal shape.

FIG. 13 shows only a case where the barrier rib 1312 is formed on the rear substrate 1311, but the barrier rib 1312 may be formed on at least one of the front substrate 1301 and the rear substrate 1311.

A predetermined discharge gas may be filled within the discharge cell partitioned by the barrier rib 1312.

Furthermore, when an address discharge is generated, a phosphor layer 1314 that emits visible light for displaying an image may be formed within the discharge cell partitioned by the barrier rib 1312. For example, red R, green G, and blue B phosphor layers may be formed.

Furthermore, in addition to the red R, green G, and blue B phosphor layers, white W and/or yellow Y phosphor layer(s) may be further formed.

Furthermore, a width in the phosphor layer 1314 of the red R, green G, and blue B discharge cells may be substantially equal to each other or a width in at least one thereof may be different from that of others. For example, when a width of the phosphor layer 1314 in at least one of the red R, green G, and blue B discharge cells is different from that of other discharge cells, a width of the phosphor layer 1314 in the green G and blue B discharge cells may be thicker than that of the phosphor layer 1314 in the red R discharge cell. Here, a width of the phosphor layer 1314 in the green G discharge cell may be substantially equal to or different from that of the phosphor layer 1314 in the blue B discharge cell.

The above description describes only an example of the plasma display panel that may be comprised in the plasma display apparatus according to an implementation of this document and an implementation of this document is not limited to the plasma display panel having the above structure. For example, in the above description, although each of the upper dielectric layer 1304 and the lower dielectric layer 1315 are formed in only one layer, but at least one of the upper dielectric layer and the lower dielectric layer may be formed in a plurality of layers.

Furthermore, in order to prevent reflection of external light due to the barrier rib 1312, a black layer (not shown) that can absorb external light may be further formed in an upper part of the barrier rib 1312.

Furthermore, a black layer (not shown) may be further formed in a specific position on the front substrate 1301 corresponding to the barrier rib 1312.

Furthermore, the third electrode 1313 formed on the rear substrate 1311 may have substantially the same width or thickness, but a width or a thickness within the discharge cell may be different from that in the outside of the discharge cell. For example, a width or a thickness at the inside of the discharge cell may be wider or thicker than that at the outside of the discharge cell.

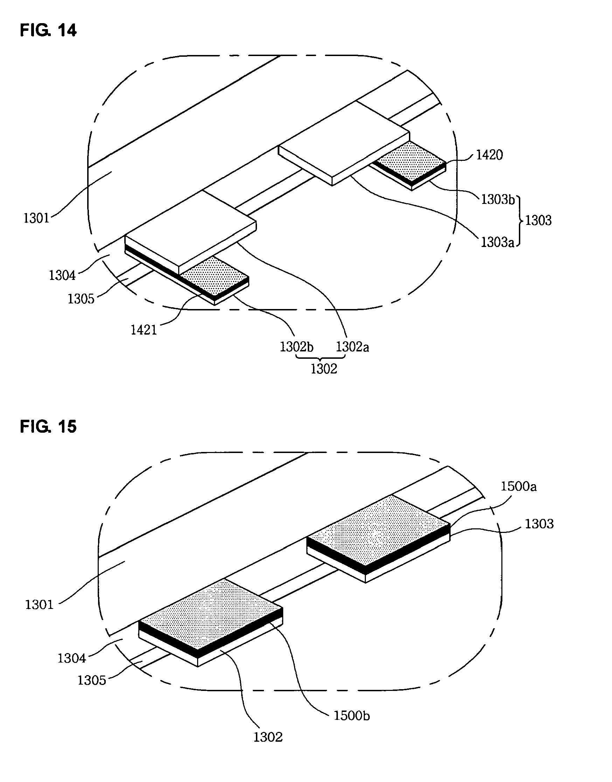

FIG. 14 is a view illustrating an example in which at least one of a first electrode or a second electrode is a plurality of layers.

Referring to FIG. 14, at least one of the first electrodes 1302 or the second electrode 1303 may be formed in a plurality of layers, for example, two layers.

For example, considering light transmittance and electrical conductivity, light generated in a discharge cell emits to the outside and in order to secure driving efficiency, at least one of the first electrode 1302 and the second electrode 1303 may comprise bus electrodes 1302b and 1303b comprising substantially a non-transparent material such as silver (Ag) and transparent electrodes 1302a and 1303a comprising a transparent material such as transparent indium tin oxide (ITO).

If the first electrode 1302 and the second electrode 1303 comprise transparent electrodes 1302a and 1303a, visible light generated within the discharge cell may be effectively emitted to the outside of the plasma display panel.

Furthermore, in a case where the first electrode 1302 and the second electrode 1303 comprise only the transparent electrodes 1302a and 1303a, electrical conductivity of the transparent electrodes 1302a and 1303a is relatively low, thereby decreasing driving efficiency. If the first electrode 1302 and the second electrode 1303 comprise the bus electrodes 1302b and 1303b, low electrical conductivity of transparent electrode 1302a and 1303a that may cause decrease of driving efficiency can be compensated.

When the first electrode 1302 and the second electrode 1303 comprise the bus electrodes 1302b and 1303b, black layers 1420 and 1421 may be further provided between the transparent electrodes 1302a and 1303a and the bus electrodes 1302b and 1303b in order to prevent reflection of external light due to the bus electrodes 1302b and 1303b.

FIG. 15 is a view illustrating an example in which at least one of a first electrode or a second electrode is one layer.

Referring to FIG. 15, the first electrode 1302 (Y) and the second electrode 1303 (Z) are one layer. For example, in FIG. 14, the first electrode 1302 (Y) and the second electrode 1303 (Z) may be an (ITO-Less) electrode in which the transparent electrodes 1302a or 1303a are omitted.

At least one of the first electrode 1302 (Y) and the second electrode 1303 (Z) may comprise a metal material that is substantially non-transparent and that has electrical conductivity. For example, at least one of the first electrode 1302 (Y) and the second electrode 1303 (Z) may comprise a material that has excellent electrical conductivity such as silver (Ag), copper (Cu), and aluminum (Al) and that is more inexpensive than a transparent material, for example, ITO.

Furthermore, at least one of the first electrode 1302 (Y) and the second electrode 1303 (Z) may have a color darker than the upper dielectric layer 1304 of FIG. 13.

When at least one of the first electrodes 1302 (Y) and the second electrode 1303 (Z) is one layer, a manufacturing process thereof is simpler than a case of FIG. 14. For example, in the case of FIG. 14, in a process of forming the first electrode 1302 (Y) and the second electrode 1303 (Z), the bus electrodes 1302b and 1303b should be again formed after forming the transparent electrodes 1302a and 1303a. However, since a case of FIG. 15 has a one layer structure, the first electrode 1302 (Y) and the second electrode 1303 (Z) can be formed with one process.

Furthermore, as in FIG. 15, if the first electrode 1302 (Y) and the second electrode 1303 (Z) are formed in one layer, a manufacturing process becomes simple and since a transparent material such as ITO that is relatively expensive may be not used, a manufacturing cost can be reduced.

Black layers 1500a and 1500b that prevents discoloration of the front substrate 1301 and that has a color darker than at least one of the first electrode 1302 (Y) and the second electrode 1303 (Z) may be further provided between the first electrode 1302 (Y), the second electrode 1303 (Z), and the front substrate 1301. That is, when the front substrate 1301 and the first electrode 1302 (Y) or the second electrode 1303 (Z) come in direct contact with each other, a migration phenomenon may be generated in which a predetermined area of the front substrate 1301 that come in direct contact with the first electrode 1302 (Y) or the second electrode 1303 (Z) is discolored into yellow, the black layers 1500a and 1500b can prevent discoloration of the front substrate by preventing the migration phenomenon.

The black layers 1500a and 1500b may comprise a black material having substantially dark color, for example, rubidium (Rb).

If the black layers 1500a and 1500b are provided between the front substrate 1301, the first electrode 1302 (Y), and the second electrode 1303 (Z), generation of reflected light can be prevented even if the first electrode 1302 (Y) and the second electrode 1303 (Z) are made of a material having high reflectivity.

A structure of a plasma display panel that may be comprised in a plasma display apparatus according to an implementation of this document may be variously changed.

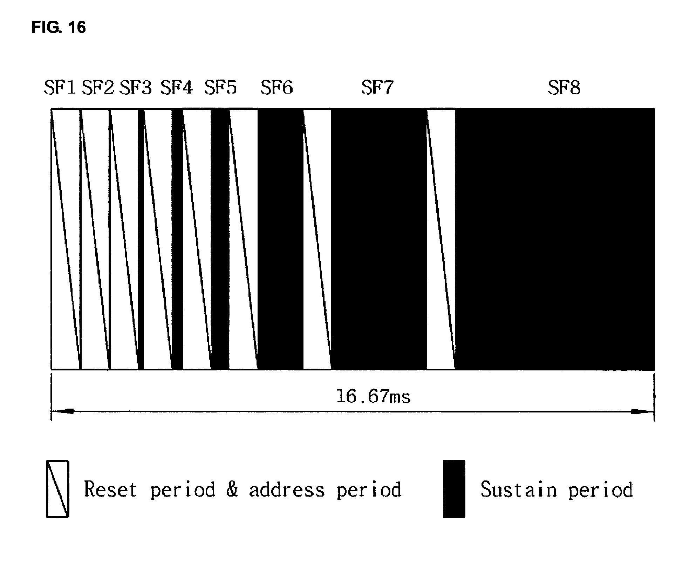

FIG. 16 is a view illustrating an image frame for embodying a gray level of an image in a plasma display apparatus according to an implementation of this document.

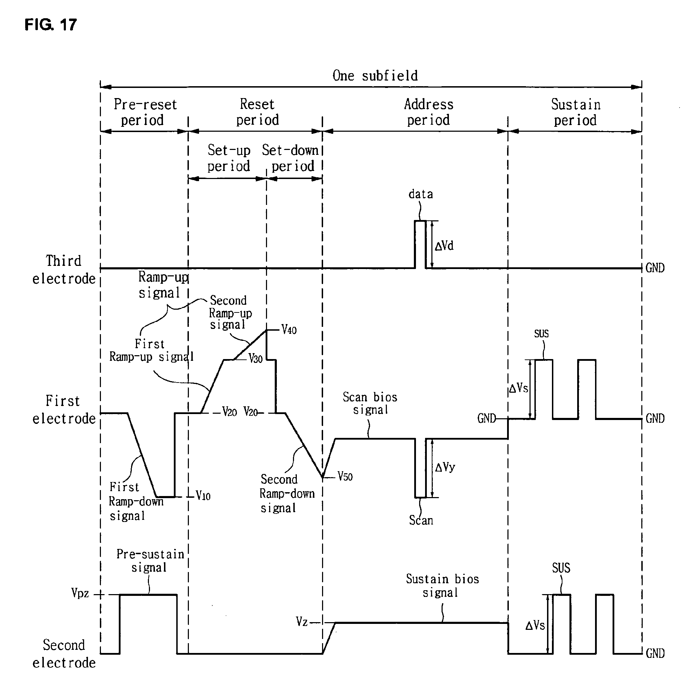

FIG. 17 is a view illustrating an example of an operation of a plasma display apparatus according to an implementation of this document.

First, referring to FIG. 16, an image frame for embodying a gray level of an image in a plasma display apparatus according to an implementation of this document may be divided into a plurality of subfields having the different light emitting number.

Furthermore, although not shown in the figure, at least one of a plurality of subfields may be again divided into a reset period for initializing all discharge cells, an address period for selecting a cell to be discharged, and a sustain period for embodying a gray level according to the discharge number.

For example, in order to display an image with 256 gray levels, for example, one image frame is divided into 8 subfields SF1 to SF8 as in FIG. 16, and each of 8 sub-fields SF1 to SF8 may be again divided into a reset period, an address period, and a sustain period.

By controlling the number of a sustain signal supplied in a sustain period, a gray level weight of a corresponding subfield may be set. That is, a predetermined gray level weight may be set in each subfield by using a sustain period. For example, a gray level weight of each subfield may be determined so that a gray level weight of each subfield is increased in a ratio of 2ⁿ (n = 0, 1, 2, 3, 4, 5, 6, 7) in a method of setting a gray level weight of a first subfield to 2⁰ and a gray level weight of a second subfield to 2¹. By controlling the number of a sustain signal supplied in a sustain period of each subfield according to a gray level weight in each subfield, a gray level of various images can be embodied.

The plasma display panel according to an implementation of this document uses a plurality of image frames so as to embody an image, for example, to display an image of one second. For example, in order to display an image of one second, 60 image frames are used. In this case, a length T of one image frame may be 1/60 second, that is, 16.67ms.

FIG. 16 shows only a case where one image frame comprises 8 subfields. However, the number of subfields constituting one image frame may be variously changed. For example, one image frame may be composed of 12 subfields from a first subfield to a 12-th subfield or 10 subfields.

Furthermore, in FIG. 16, in one image frame, subfields are arranged in increasing order of a gray level weight, but in one image frame, subfields may be arranged in decreasing order of a gray level weight or regardless of a gray level weight.

Next, an example of an operation of a plasma display panel according to an implementation of this document in any one subfield among a plurality of subfields comprised in an image frame as in FIG. 16 is shown in FIG. 17.

First, a first ramp-down signal may be supplied to the first electrode Y in a pre-reset period before a reset period.

Furthermore, while the first ramp-down signal is supplied to the first electrode Y, a pre-sustain signal having a polarity direction opposite to the first ramp-down signal may be supplied to the second electrode Z.

Here, the first ramp-down signal supplied to the first electrode Y may gradually fall to a 10-th voltage V10.

Furthermore, a pre-sustain signal may substantially constantly sustain a pre-sustain voltage Vpz. Here, the pre-sustain voltage Vpz may be approximately equal to a voltage of a sustain signal SUS supplied during a sustain period, i.e., a sustain voltage Vs.

In this way, in a pre-reset period, if the first ramp-down signal is supplied to the first electrode Y and a pre sustain signal is supplied to the second electrode Z, a predetermined polarity of wall charges are stacked on the first electrode Y and wall charges having a polarity opposite to the first electrode Y are stacked on the second electrode Z. For example, positive (+) wall charges may be stacked on the first electrode Y and negative (-) wall charges may be stacked on the second electrode Z.

Accordingly, in a reset period, an enough magnitude of set-up discharge may be generated and initialization may be fully stably performed.

Furthermore, in a reset period, an enough magnitude of set-up discharge may be generated even if a voltage of a ramp-up signal supplied to the first electrode Y becomes smaller.

In order to secure a driving time, a pre-reset period may be comprised before a reset period in a subfield arranged in the first in time among subfields of an image frame or a pre-reset period may be comprised before a reset period in two or three subfields among subfields of an image frame.

Otherwise, a pre-reset period may be omitted in all subfields.

After a pre-reset period, in a set-up period of a reset period for initialization, a ramp-up signal having a polarity direction opposite to the first ramp-down signal may be supplied to the first electrode Y.

Here, a ramp-up signal may comprise a first ramp-up signal that gradually rises with a first slope from a 20-th voltage V20 to a 30-th voltage V30 and a second ramp-up signal that rises with a second slope from the 30-th voltage V30 to a 40-th voltage V40.

In the set-up period, a weak dark discharge, i.e., a set-up discharge is generated within a discharge cell by a ramp-up signal. More or less wall charges may be stacked within the discharge cell by the set-up discharge.

Here, it is preferable that a second slope of the second ramp-up signal is smoother than a first slope thereof. In this way, if the second slope is smoother than the first slope, a voltage relatively fast rises until a set-up discharge is generated and a voltage relatively slowly raises while a set-up discharge is generated, thereby reducing an amount of light generating by the set-up discharge.

Accordingly, contrast characteristics can be improved.

In a set-down period after a set-up period, after the ramp-up signal, a second ramp-down signal having a polarity direction opposite to the ramp-up signal may be supplied to the first electrode Y.

Here, the second ramp-down signal may gradually fall from the 20-th voltage V20 to a 50-th voltage V50.

Accordingly, a feeble erase discharge, i.e., a set-down discharge is generated within a discharge cell. Wall charges of extent to stably generate an address discharge are uniformly sustained within the discharge cell by the set-down discharge.

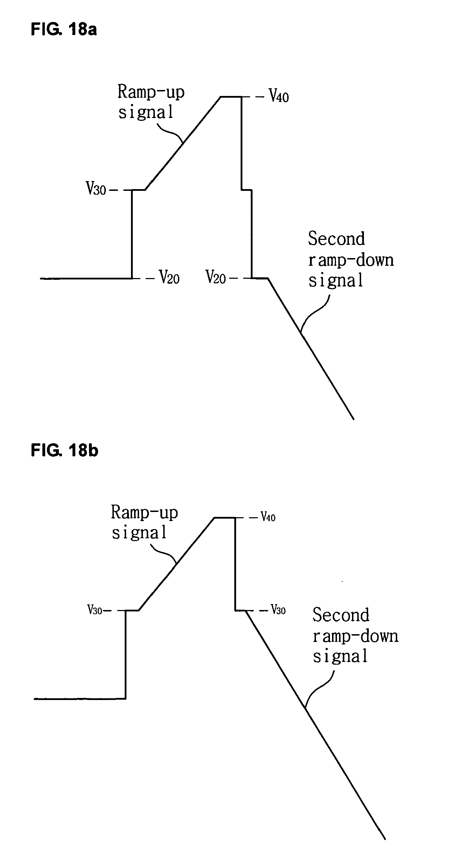

FIGS. 18A and 18B are views illustrating another form of a ramp-up signal or a second ramp-down signal.

First, referring to FIG. 18A, the ramp-up signal abruptly rises to the 30-th voltage V30 and then gradually rises from the 30-th voltage V30 to the 40-th voltage V40.

In this way, the ramp-up signal may gradually rise with a different slope in two steps as in FIG. 17 and may gradually rise in one step as in FIG. 18A, that is, may be changed in various forms.

Next, referring to FIG. 18B, in the second ramp-down signal, a voltage gradually falls from the 30-th voltage V30.

In this way, in the second ramp-down signal, since a falling time point of a voltage may be changed, the second ramp-down signal may be changed in various forms.

In an address period after a reset period, a scan bias signal of substantially sustaining a voltage higher than the 50-th voltage V50 of the second ramp-down signal may be supplied to the first electrode Y.

Furthermore, a scan signal (Scan) that falls by a scan voltage ΔVy from a scan bias signal may be supplied to all of the first electrodes Y1 to Yn.

For example, a first scan signal (Scan 1) is supplied to a first Y1 of first electrodes among a plurality of first electrodes Y, then a second scan signal (Scan 2) is supplied to a second Y2 of the first electrodes, and a n-th scan signal (Scan n) is supplied to a n-th of the first electrodes Yn.

A width of the scan signal (Scan) may be varied in a subfield unit. That is, a width of the scan signal (Scan) in at least one subfield may be different from that of a scan signal (Scan) in other subfields. For example, a width of the scan signal (Scan) in a subfield positioned behind in time may be smaller than that of the scan signal (Scan) in a subfield positioned front in time. Furthermore, a width of a scan signal (Scan) depending on an arrangement order of a subfield may be gradually decreased as in 2.6 µs, 2.3 µs, 2.1 µs, and 1.9 µs or may be decreased as in 2.6 µs, 2.3 µs, 2.3 µs, 2.1 µs ...... 1.9 µs, and 1.9 µs.

In this way, when a scan signal (Scan) is supplied to the first electrode Y, a data signal rising by a magnitude ΔVd of a data voltage may be supplied to the third electrode X to correspond to the scan signal.

As the scan signal (Scan) and the data signal (Data) are supplied, a wall voltage by wall charges generated during a reset period is added to a voltage difference between a voltage of the scan signal (Scan) and a data voltage Vd of the data signal and thus an address discharge may be generated within a discharge cell in which the voltage Vd of the data signal is supplied.

In an address period, a sustain bias signal may be supplied to the second electrode Z in order to prevent that an address discharge becomes unstable by interference of the second electrode Z.

Here, a sustain bias signal may substantially constantly sustain a sustain bias voltage Vz larger than a ground level GND of voltage and smaller than a voltage of a sustain signal supplied in a sustain period.

Thereafter, in a sustain period for displaying an image, the sustain signal SUS may be alternately supplied to the first electrode Y and/or the second electrode Z. This sustain signal SUS may have a voltage magnitude of ΔV.

If the sustain signal SUS is supplied, a sustain voltage Vs of a sustain signal SUS is added to a wall voltage within the discharge cell in a discharge cell selected by an address discharge and thus a sustain discharge, i.e., a display discharge may be generated between the first electrode Y and the second electrode Z.

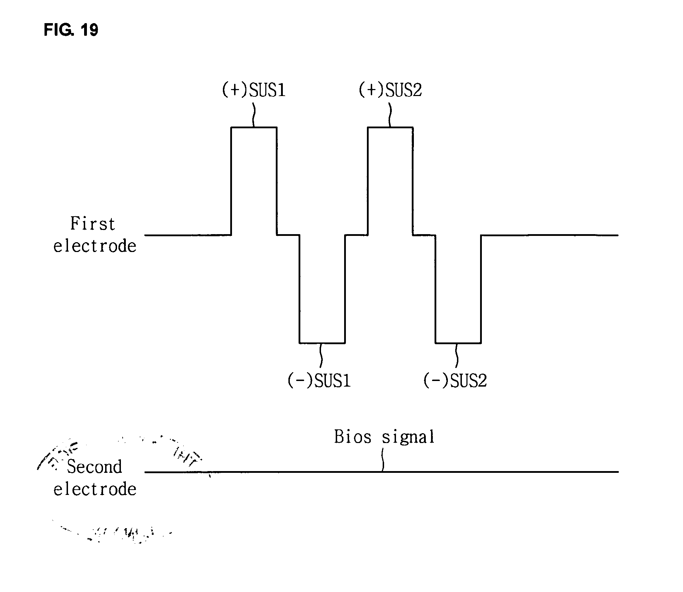

FIG. 19 is a view illustrating another type of a sustain signal.

Referring to FIG. 19, a positive (+) sustain signal and a negative (-) sustain signal are alternatively supplied to any one of the first electrode Y and the second electrode Z, for example, the first electrode.

While a positive sustain signal and a negative sustain signal are supplied to any one electrode, a bias signal may be supplied to the remaining electrode, for example, the second electrode Z.

Here, a bias signal may substantially constantly sustain a ground level GND of voltage.

As in FIG. 19, when a sustain signal is supplied to only any one of the first electrode Y and the second electrode Z, only one driving board in which circuits for supplying the sustain signal to any one of the first electrode Y and the second electrode Z are disposed may be provided.

Accordingly, an entire size of a driver can be reduced and thus a manufacture cost can be reduced.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A plasma display apparatus comprising:
a plasma display panel that displays an image; and
a filter provided to a front of the plasma display panel; the filter comprises:
a substrate;
a metal layer formed on the substrate;
a base layer formed on the substrate; and
a dark-colored part provided to the base layer;
wherein a traveling direction of the dark-colored part has a angle from 5° to 80° on the basis of the bottom of the base layer.

2. The plasma display apparatus of claim 1, wherein the metal layer comprises at least one transparent layer and at least one Silver(Ag) layer.

3. The plasma display apparatus of claim 1, wherein the metal layer comprises a mesh type metal layer.

4. A plasma display apparatus comprising:
a plasma display panel that displays an image; and
a filter provided to a front of the plasma display panel; the filter comprising:
a substrate;
at least one transparent layer formed on the substrate;
at least one metal layer adjacently formed on the transparent layer;
a base layer formed on the substrate; and
a dark-colored part provided to the base layer.

5. The plasma display apparatus of claim 4, wherein the transparent layer has a thickness of 300Å to 800Å.

6. The plasma display apparatus of claim 4, wherein the transparent layer comprises an indium-tin oxide (ITO).

7. The plasma display apparatus of claim 4, wherein the metal layer has a thickness of 100Å to 200Å.

8. The plasma display apparatus of claim 4, wherein the metal layer comprises a silver (Ag) material.

9. The plasma display apparatus of claim 4, wherein the total layer number of the transparent layer and the metal layer is 5 to 13.

10. A plasma display apparatus comprising:
a plasma display panel that displays an image; and
a filter provided to a front of the plasma display panel; the filter comprising:
a substrate;
a mesh type metal layer that is formed on the substrate;
a base layer that is formed on the substrate; and
a dark-colored part provided to the base layer,
wherein a line width of the metal layer is 10µm to 30µm.

11. The plasma display apparatus of claim 10, wherein a shortest distance between lines of the metal layer is 200 µm to 300 µm.

12. The plasma display apparatus of claim 10, wherein the substrate comprises a glass material or a resin material.

13. The plasma display apparatus of claim 10, wherein a traveling direction of the dark-colored part has an angle from 5° to 80° on the basis of the bottom of the base layer.

14. The plasma display apparatus of claim 10, wherein a refractive index of the dark-colored part is 0.8 to 0.999 times greater than a refractive index of the base layer.

15. The plasma display apparatus of claims 10, wherein a height of the base layer is 1.01 to 2.25 times greater than a height of the dark-colored part.

16. The plasma display apparatus of claim 10, wherein a gap between the dark-colored parts in a bottom area is 1.1 to 5 times greater than a width of a base of the dark-colored part.

17. The plasma display apparatus of claim 10, wherein a gap between dark-colored parts in an upper area is 1.1 to 3.25 times greater than a gap between the dark-colored parts in a bottom area.

18. The plasma display apparatus of claim 10, wherein a height of the dark-colored part is 0.89 to 4.25 times greater than a gap between the dark-colored parts in a bottom area.

19. The plasma display apparatus of claim 10, further comprising a near-infrared ray shielding layer for absorbing or reflecting near-infrared rays.

20. The plasma display apparatus of claim 19, wherein the near-infrared ray shielding layer is made of an acryl adhesive, which is a homopolymer or copolymer that is mixed 75 to 99.89wt% of a (meta)acrylic acid ester monomer having an alkyl group of 1 to 12 carbon atoms with 0.1 to 20wt% of an α, β-unsaturated carboxylic acid monomer that is a functional monomer or 0.01 to 5 wt% of a polymerizable monomer having a hydroxyl group.
